# EUROPEAN PATENT APPLICATION

(11) **EP 2 463 046 A1**
(43) Date of publication of application: **13.06.2012**
(21) Application number: 10806217.5
(22) Date of filing: 02.08.2010
(51) Int. Cl.: B22F 1/02, H01B 1/22, H01B 5/00, H01J 11/02, H01L 21/28, H01L 21/288, H01L 21/3205, H01L 23/52, H01L 31/04, H05K 1/09

(54) **Cu-Al ALLOY POWDER, ALLOY PASTE UTILIZING SAME, AND ELECTRONIC COMPONENT**

(30) Priority: 05.08.2009 JP 2009182007
(71) Applicant: Hitachi Chemical Company, Ltd., Tokyo 163-0449 (JP)
(72) Inventor: KATO, Takahiko, Hitachi-shi Ibaraki 319-1292 (JP); NAITO, Takashi, Hitachi-shi Ibaraki 319-1292 (JP); AOYAGI, Takuya, Hitachi-shi Ibaraki 319-1292 (JP); YAMAMOTO, Hiroki, Hitachi-shi Ibaraki 319-1292 (JP); YOSHIDA, Masato, Tsukuba-shi Ibaraki 300-4247 (JP); KATAYOSE, Mitsuo, Tokyo 163-0449 (JP); TAKEDA, Shinji, Chikusei-shi Ibaraki 308-8521 (JP); TANAKA, Naotaka, Tsukuba-shi Ibaraki 300-4247 (JP); ADACHI, Shuichiro, Hitachinaka-shi Ibaraki 312-0003 (JP)
(74) Representative: Beetz & Partner
(86) International application number: PCT/JP2010/004862
(87) International publication number: WO 2011/016217

(57) **Abstract**

In an electronic component having a wiring and/or an electrode prepared through firing of a paste or in an electronic component having a wiring in contact with a glass or glass ceramic member, provided is an electronic component using a Cu-based wiring material which less suffers from increase in electric resistance due to oxidation, which less causes bubbles in the glass or glass ceramic, and has satisfactory migration resistance. The Cu-Al alloy powder includes a Cu-Al alloy powder including Cu and, preferably, 50 percent by weight or less of Al; and an aluminum oxide film having a thickness of 80 nm or less and being present on the surface of the Cu-Al alloy powder. The powder, when compounded with a glass or glass ceramic material to give a paste, can be used to form wiring (interconnections), electrodes, and/or contact members.

## Description

### Technical Field

The present invention relates to a copper-based wiring material for a wiring, an electrode and/or a contact, which material is resistant to oxidation during the manufacture of the wiring, the electrode and/or the contact. The present invention also relates to an electronic component using the wiring material for wiring.

### Background Art

When electronic components having, for example, wirings, electrodes, and/or contacts can be manufactured using a manufacturing method in which the electronic components do not contact an oxidative atmosphere, pure copper (Cu) is used for a wiring or electrode material as represented by LSI wiring. Independently, in a typical manufacturing method typically for a large-screen plasma display, a metal wiring is embedded in a glass dielectric, and the embedded metal wiring is subjected to a heat treatment at high temperatures of, for example, 400°C or higher in an oxidative atmosphere.

Further independently, an electrode for a solar cell is subjected to a heat treatment (firing) at a high temperature of 800°C or higher in the air (in the atmosphere). For this reason, a wiring, such as a Ag wiring, having resistance to oxidization even in the heat treatment at high temperatures has been practically used. Meanwhile, application of a Cu-based material having high reliability to the wiring is strongly desired from the viewpoints of cost reduction and improvement in migration resistance. However, Cu, when used, undergoes oxidation at a temperature of higher than 200°C, so that bubbles are generated in the glass dielectric, and the Cu wiring has a remarkably increased electric resistance and/or becomes dielectric. Therefore, under the present circumstances, application of a pure Cu metal alone to the wiring and electrode has not been realized yet in the electronic component products undergone the manufacturing method at a high temperature in an oxidative atmosphere.

In a conventional technique, an electronic component material has been known in which weatherability of Cu as a whole is improved by using Cu as a principal component, containing 0.1 to 3.0 percent by weight of Mo, and homogeneously mixing Mo in a grain boundary of Cu (for example, Patent Literature (PTL) 1). In this conventional technique, addition of Mo is essential, and an attempt to further improve the weatherability compared with the case of adding Mo alone has been made. In this attempt, one or more elements selected from the group consisting of Al, Au, Ag, Ti, Ni, Co, and Si is added in a total amount of 0.1 to 3.0 percent by weight, in addition to Mo. However, the literature points out that this alloy rather has deteriorated weatherability when added with a total of 3.0 percent by weight or more of one or more elements selected from the group consisting of Al, Au, Ag, Ti, Ni, Co, and Si.
Additionally, this technique, as essentially requiring the addition of Mo, suffers from high material cost and is therefore not suitable for practical use in electronic component products of a lower market price.

### Citation List

### Patent Literature

PTL 1: Japanese Unexamined Patent Application Publication (JP-A) No. 2004-91907

### Summary of Invention

### Technical Problem

As used herein, the term "wiring, electrode and/or contact" means and includes a wiring, an electrode, and a contact; the term "wiring" refers to, in a plasma display, an article in the form of a wiring or interconnection which has been formed by applying a paste containing an electroconductive metal powder and a glass to a substrate, followed by firing. In a solar cell, it is referred to as a front silver electrode (with the rear side being an Al electrode). A portion connecting between an article in the form of wiring and a conductor for driving a system is referred to as a contact. A powder mixture or paste for the formation of these members is herein referred to as a "wiring material".

From the viewpoint of cost reduction and improvement in migration resistance, it is strongly desired to adopt a Cu-based material having higher reliability to wiring as a material for a wiring, an electrode, or a contact used for the electronic components. However, as mentioned above, when the Cu-based material is used as the wiring material or the electrode material in the electronic components having wirings and/or electrodes manufactured by firing of a paste or those including the wiring and the electrode in coexistence with a glass or glass ceramic, the material may be oxidized to have an abruptly increased electric resistance and/or to cause bubbles in the glass or glass ceramic. This is because pure Cu is rapidly oxidized and becomes dielectric during a manufacturing method including a heat treatment process at a high temperature of 200°C or higher in an oxidative atmosphere; and an oxide layer formed typically on a surface of a wiring, an electrode, or a contact made of pure Cu reacts with the glass or glass ceramic in contact with this oxide layer at a high temperature to cause bubbles. The remarkable increase in electric resistance, and the generation of bubbles, which causes problems such as reduction in withstanding voltage, impede the manufacturing of these electronic components.

In consideration of these problems, an obj ect of the present invention is to provide an electronic component using a Cu-based wiring material, which electronic component includes a wiring, an electrode and/or a contact manufactured through firing of a paste or has a wiring in contact with a glass or glass ceramic member, in which the Cu-based wiring material less suffers from increase in electric resistance due to oxidation, less causes the generation of bubbles in the glass or glass ceramic, and has satisfactory migration resistance.

### Solution to Problem

The present invention provides, in an aspect, an electronic component which includes a wiring, and/or an electrode in contact with a glass or glass ceramic member, or which includes a wiring, an electrode and/or a contact member formed by preparing a paste together with a glass or glass ceramic, followed by firing. In the electronic component, the wiring, electrode, and/or contact member includes an alloy powder particle containing Cu and Al; and an aluminum oxide film (Al₂O₃) having a thickness of 80 nm or less and covering a surface of the alloy powder particle. Exemplary structures of the wiring in contact with the glass or glass ceramic member include a structure in which the wiring is formed on a surface of the glass or glass ceramic member; a structure in which a surface of the wiring is covered with the glass or glass ceramic member; and a structure in which the wiring is arranged in a hole provided in the glass or glass ceramic member.

The present invention provides, in another aspect, a wiring material formed by blending at least an electroconductive metal material powder and a glass powder and firing the resulting blend, in which the electroconductive metal component includes a Cu-Al alloy powder particle formed from an alloy of Cu and Al; and an aluminum oxide film (Al₂O₃) covering a surface of the Cu-Al alloy powder particles and having a thickness of 80 nm or less.

### Advantageous Effects of Invention

The present invention can provide an electronic component having a wiring in contact with a glass or glass ceramic member, in which the electronic component uses a Cu-basedwiringmaterial that less causes the generation of bubbles in the glass or glass ceramic and has satisfactory migration resistance.

In addition, the present invention can provide a Cu-based wiring material for a wiring, an electrode and/or a contact member. This wiring material is resistant to oxidation even in a heat treatment in an oxidative atmosphere and less suffers from increase in electric resistance.

### Brief Description of Drawings

[Fig. 1] Fig. 1 depicts a cross-sectional transmission electron microscopic (TEM) image of a coating prepared from a Cu-Al alloy paste; and an electron diffraction pattern of a film thereof.
[Fig. 2] Fig. 2 is a schematic cross sectional view of a double-sided electrode crystalline silicon solar cell element using a material according to the present invention.
[Fig. 3] Fig. 3 is a schematic diagram of a light-receiving surface of the double-sided electrode crystalline silicon solar cell element using the material according to the present invention.
[Fig. 4] Fig. 4 is a schematic diagram of a back surface of the double-sided electrode crystalline silicon solar cell element using the material according to the present invention.
[Fig. 5] Fig. 5 is a schematic diagram of a back-contact cell (back-electrode) crystalline silicon solar cell using a material according to the present invention.
[Fig. 6] Fig. 6 is a cross-sectional view of a plasma display using a material according to the present invention.
[Fig. 7] Fig. 7 depicts how the specific resistance of an electronic component wiring varies depending on the content of a Cu-Al alloy powder in a mixture of the electroconductive metal powder and a glass powder.
[Fig. 8] Fig. 8 is a photomicrograph obtained through observation under an optical microscope, illustrating bubbles generated in a dielectric glass from wiring of a comparative electronic component using pure Cu.
[Fig. 9] Fig. 9 is a cross-sectional view of a low-temperature co-fired ceramic multilayer wiring board using a wiring material according to the present invention.
[Fig. 10] Fig. 10 is an explanatory drawing illustrating heat treatment conditions upon firing of a multilayer wiring board.
[Fig. 11] Fig. 11 depicts the particle size distribution of a Cu-Al alloy powder according to the present invention having an average particle size of 5 µm or less.
[Fig. 12] Fig. 12 is a scanning electron micrograph (SEM) of a Cu-Al alloy powder according to the present invention including a blend of a spherical powder and a flaky powder.
[Fig. 13] Fig. 13 illustrates the particle size distribution of a Cu-Al alloy powder according to the present invention having a maximum of particle size of 8 µm or less.

### Description of Embodiments

A wiring material of Cu-Al alloy powder according to the present invention includes a binary alloy containing Al in a content of 50 percent by weight or less, with the remainder being Cu and inevitable impurities. The alloy preferably contains Al in a content of 1 percent by weight or more. The Cu-Al alloy wiring material according to the present invention is used as a wiring, and/or an electrode in contact with a glass or glass ceramic member or is used as a wiring, an electrode and/or a contact member formed by preparing a paste with a glass or glass ceramic member and firing the paste. The present invention further provides a material for a wiring, an electrode and/or a contact prepared by blending the binary alloy powder with a glass powder and firing the resulting mixture. If Al is added to Cu in an amount more than 50 percent by weight, θ phase precipitates upon preparation of the powder alloy, and this impedes the formation of an alloy powder having a uniform composition. If Al is contained in the material mixture in a content of more than 15 percent by weight, γ₂ phase becomes predominant, thus also impeding the formation of an alloy powder having a uniform composition. For these reasons, the Al content is preferably from 1 to 15 percent by weight.

A Cu-Al alloy powder prepared typically through water atomization is sized and thereby yields a powder material having a desired average particle size. The average particle size should be equal to or less than the thickness of a wiring, an electrode and/or a contact to be produced. Accordingly, the average particle size is preferably 5 µm or less when the powder material is used, for example, in a solar cell. The Cu-Al alloy powder material and a glass powder are dispersed in a solvent to give a paste, from which a coating is formed typically through printing such as screen process printing, and the coating is fired in the atmosphere (in the air). The surfaces of the Cu-Al alloy powder particles are covered with an oxide film. The oxide film has a thickness of 80 µm or less. The oxide film is enough to be one formed by natural oxidation and having a thickness of, at minimum, 20 nm or more so as to exhibit advantageous effects of the present invention.

For example, wiring pastes were prepared by mixing a Cu-Al alloy powder having an average particle size of from 1 to 2 µm with a glass powder having an average particle size of 1 µm in different contents, and further adding a binder and a solvent to the mixture. The glass powder used herein was a lead-free low-temperature softening glass having a softening point of around 450°C; the binder was ethylcellulose; and the solvent was butyl Carbitol acetate. The prepared wiring pastes were applied to a glass substrate through printing, heated at 630°C in the atmosphere for 30 minutes, and thereby yielded wirings. Electric resistance of the prepared wirings was measured, from which specific resistance was determined. The results demonstrated that wirings containing the Cu-Al alloy powder in a content of 64 percent by weight or more and the glass powder in a content of 35 percent by weight or less are hardly oxidized and have a sufficiently low specific resistance. Accordingly, the glass powder is preferably contained in a content of 35 percent by weight or less.

Exemplary binders for use in the present invention include ethylcellulose, carboxymethylcellulose, nitrocellulose, poly(vinyl alcohol)s, polyvinylpyrrolidones, acrylic resins, vinyl acetate-acrylic ester copolymers, poly (vinyl butyral) s, phenol-modified alkyd resins, castor oil fatty acid-modified alkyd resins, epoxy resins, phenol resins, and rosin ester resins.

It is difficult to determine unambiguously the compositional ratio between the spherical powder and the flaky powder because of tradeoffs between the amount of crystal defects of the flaky powder and the degree of adhesion between the spherical powder and the flaky powder. The compositional ratio, however, is preferably such that the coating after firing has an electric resistance as low as possible.

Such a flaky powder is generally formed by crushing spherical particles. In this process, a subgrain boundary due to transition or tangled transition is generated in the flaky powder, and this region serves as a selective oxidation pathway. To avoid this, when a flaky powder as prepared is used without any treatment, the content thereof is preferably 20 percent by weight or less. In contrast, if a flaky powder which has been subjected to a heat treatment for crystal defects healing before blending is used, the ratio (in percent by weight) of the spherical powder to the flaky powder is preferably from 40: 60 to 60: 40 for minimizing the electric resistance, because the resulting flaky powder has oxidation resistance near to that of the spherical powder.

The above description is summarized as follows.
Specifically, some preferred conditions relating to the present invention are indicated below. It should be noted, however, that the following description does not cover all conditions.
(1) Chemical composition of Cu-Al alloy: Al in a content of from 1 to 50 percent by weight, with the remainder being Cu and inevitable impurities.
(2) Component other than Cu-Al: substantially none.
(3) Average particle size of Cu-Al alloy powder: 5 µm or less for a spherical powder; and 10 µm or less in terms of major axis for a flaky powder. Maximum of the particle size of spherical particles is 30 µm or less.
(4) Compositional ratio of spherical powder and flaky powder:
   (a) Untreated flaky alloy powder: in a content of 20 percent by weight or less based on the total amount of the alloy powder.

(b) Heat-treated flaky alloy powder: in a content of from 40 to 60 percent by weight based on the total amount of the alloy powder.
   (5) Thickness of oxide film of Cu-Al alloy powder: from 20 to 80 nm.
   (6) Paste composition
      (a) Solid contents basis: Cu-Al alloy powder in a content of from 64 to 98 percent by weight; glass powder in a content of from 0 to 35 percent by weight; and binder in a content of from 1 to 10 percent by weight.

(b) Total weight basis: Cu-Al alloy powder in a content of from 60 to 85 percent by weight; glass powder in a content of from 0 to 25 percent by weight; binder in a content of from 1 to 10 percent by weight; and solvent in a content of from 5 to 15 percent by weight.

(c) Paste further containing another metal powder: Cu-Al alloy powder in a content of from 55 to 80 percent by weight; other metal powder in a content of from 0 to 15 percent by weight; glass powder in a content of from 0 to 25 percent by weight; binder in a content of from 1 to 10 percent by weight; and solvent in a content of from 5 to 15 percent by weight. (7) Paste containing no glass powder: Cu-Al alloy in a content of from 70 to 95 percent by weight; and phosphoric acid in a content of from 5 to 30 percent by weight.

Exemplary solvents for use in the present invention include known solvents used typically for electroconductive pastes, such as butyl Carbitol acetate, hexane, cyclohexane, toluene, dicyclopentadiene, dichloroethylene, dichloroethane, dichlorobenzene, tetrahydrofuran, furan, tetrahydropyran, pyran, dioxane, 1,3-dioxolane, trioxane, N,N-dimethylformamide, N,N-dimethylacetamide, dimethyl sulfoxide, diethyl sulfoxide, acetone, methyl ethyl ketone, diethylketone, cyclohexanone, ethanol, 2-propanol, 1-butanol, diacetone alcohol, 2,2,4-trimethyl-1,3-pentanediol monoacetate, 2,2,4-trimethyl-1,3-pentanediol monopropiorate, 2,2,4-trimethyl-1,3-pentanediol monobutyrate, 2,2,4-trimethyl-1,3-pentanediol monoisobutyrate, 2,2,4-triethyl-1,3-pentanediol monoacetate, ethylene glycol monobutyl ether acetate, diethylene glycol monobutyl ether acetate, butyl Cellosolve, diethylene glycol diethyl ether, α-terpinene, α-terpineol, myrcene, allo-ocimene, limonene, dipentene, α-pinene, β-pinene, carvone, ocimene, and phellandrene.

Investigation results made by the present inventors which have led to the present invention, and embodiments of the present invention will be illustrated in detail below.

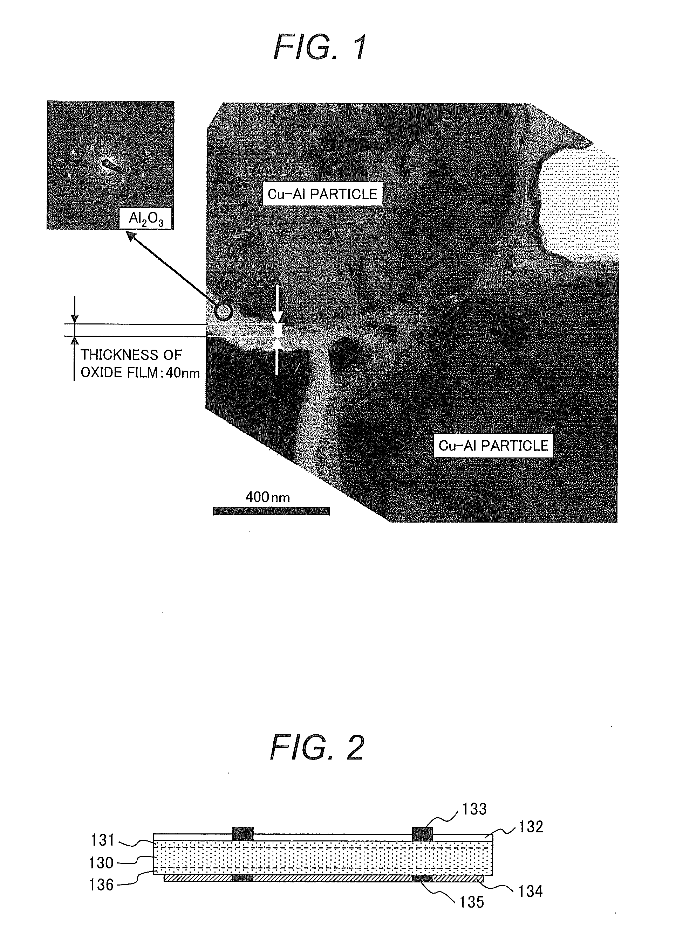

Fig. 1 depicts an exemplary photomicrograph of a transmission electron microscopic (TEM) specimen observed under a TEM. The TEM specimen was prepared by preparing an alloy powder containing Cu and Al through water atomization; blending the alloy powder with a glass, a solvent, and a resin to give a Cu-Al alloy paste; applying the paste to a silicon substrate by printing to form a coating; firing the coating at 800°C in the atmosphere for 1 minute to form a thin-film electrode on the silicon substrate; and processing the thin-film electrode by a focused ion beam (FIB) process to give the TEM specimen. The presence of an aluminum oxide film (Al₂O₃) 40 nm thick on the surface of the Cu-Al alloy particles is demonstrated by the TEM observation of the cross section of coating, and a nanoelectron diffraction pattern obtained from the aluminum oxide film shown in the upper left in Fig. 1. The coating has an electric resistance of 5x 10⁻⁶ Ωcm or less, and Cu-Al alloy particles are found to be necked with each other. The present inventors made electrode forming tests at different Al contents in the Cu-Al alloy under various conditions and have found that Cu-Al particles having an electric resistance of this level bear an aluminum oxide film (Al₂O₃) having a thickness of 40 nm on their surface.

The atomization process herein includes the steps of melting a Cu-Al alloy; powdering the molten alloy by spraying from a nozzle; drying the powder; classifying the dried powder; blending the classified powder; and deoxidizing/dehydrating. The similar results were obtained even when the classification of the powder was performed by dry gas classification or wet submerged classification. The atomized powder was subjected to a thermal analysis in the atmosphere as in the firing of the coating and was found to have a weight gain upon oxidation of about 1 percent by weight. The weight gains of Cu-Al alloy powders were measured at different parameters including the Al content in Cu and the heat treatment conditions at different temperatures of from 600°C to 900°C in the atmosphere. In addition, fired coatings were prepared from pastes using the Cu-Al alloy powders, electric resistances thereof were measured, and the relationships between the electric resistance and the parameters were investigated. As a result, it was found that Cu-Al alloy powders which attain an electric resistance of 5x 10⁻⁶ Ωcm or less have a weight gain on oxidation of 5 percent by weight or less.

Independently, easy control of the particle size distribution of the Cu-Al alloy powder to be used is important for cost reduction in the method for manufacturing the formation of an electrode, a wiring, and/or a contact member of an electronic component. When a Cu-Al alloy powder is manufactured by the steps of melting a Cu-Al alloy; powdering the molten alloy by spraying from a nozzle; drying the power; classifying the dried powder; blending the classified powder; and deoxidizing/dehydrating the powder, a yield of 90% or more with respect to the charged materials in the alloy melting step can be attained according to the present invention. This has been achieved by controlling the maximum of particle size in particle size distribution of Cu-Al alloy powder (spherical) to a diameter of 30 µm or less and controlling the average particle size of the alloy powder to 5 µm or less. In addition, a flaky Cu-Al alloy powder was manufactured from the powder (spherical) typically with a ball mill, and the flaky powder was mixed with the powder (spherical) to give a Cu-Al alloy powder, from which an electrode was prepared. The resulting electrode was capable of having a lower electric resistance of about nine-tenths to about three-tenths that of an electrode formed from the spherical powder alone.

Returning to the cost consideration, by controlling the maximum of particle size in particle size distribution of the powder to a diameter of 5 µm or less, the resulting Cu-Al alloy powder was capable of giving an electrode having an electric resistance sufficiently lower than 5x 10⁻⁶ Ωcm and capable of being obtained in a yield of 70% or more with respect to materials charged in the alloy melting step.

As an application of the Cu-Al alloy paste containing the Cu-Al alloy powder and at least one selected from the group consisting of a glass, a solvent, and a resin, a Cu-Al alloy paste further containing at least one powder selected from the group consisting of a Ag powder, an Al powder, a Si powder, and a Au powder was prepared. This paste was also capable of forming an electrode, a wiring, and/or a contact member having oxidation resistance and electric resistance equivalent to those of the former one. This alloy paste was suitable for the manufacture of an electronic component which requires improvements in the denseness of a material powder necked in an electrode, a wiring, and/or a contact member.

Additionally, another Cu-Al alloy paste was prepared by adding to the Cu-Al alloy paste at least one selected from the group consisting of oxide powders or carbonates (for example, Na₂CO₃) of alkali metals such as Na, Li, and K, and an electrode was formed from the resulting Cu-Al alloy paste on a crystalline silicon substrate for a solar cell already bearing, on its surface, an antireflection film (silicon nitride film). The electrode exhibited further improved fire-through property. The fire-through property is such a performance that, when the antireflection film in a region below the electrode is removed, the electrode is capable of maintaining an ohmic contact with the silicon substrate.

As is described above, of electrodes, wirings, and contact members for electronic components manufactured from Cu-Al alloy powders and Cu-Al alloy pastes according to the present invention, those of good quality achieve an electric resistance of from 2 to 5x 10⁻⁶Ωcm; and even those having a worst electric resistance under various conditions can achieve an electric resistance of 50 µΩcm or less satisfactory as electric conductors for electronic components. Based on these, electronic components such as a system-on-a-film (SOF), a tape carrier package (TCP), a low-temperature co-fired ceramics (LTCC) multilayer wiring board, a plasma display panel (PDP), a liquid crystal display (LCD), an organic electroluminescence (EL) display, and a solar cell were prepared using the Cu-Al alloy pastes according to the present invention, and they were capable of exhibiting respective functions satisfactorily.

These electronic components are therefore also within the scope of the present invention. The wiring, electrode, and/or contact member formed from the Cu-Al alloy powders/pastes for electronic components according to the present invention may be part or whole of an electronic component constituting the system-on-a-film, tape carrier package, low-temperature co-fired ceramic, plasma display, liquid crystal display, organic EL display, or solar cell, and can exhibit oxidation resistance according to the present invention effectively.

In an embodiment according to the present invention, the solar cell is a crystalline silicon solar cell. In this embodiment, the electrode for a solar cell according to the present invention was capable of achieving an electric resistance of 10 µΩcm or less. Even when the crystalline silicon solar cell is a double-sided electrode solar cell or a back-contact solar cell, the solar cell integrated with an electrode prepared from any of Cu-Al alloy pastes according to the present invention achieved an efficiency equivalent to or higher than that of a conventional Ag electrode solar cell, i.e., about 15% for polycrystalline silicon, and about 18% for monocrystalline silicon.

Independently, of the electronic components, an electronic component structurally including the Cu-Al alloy electric conductor and, in contact therewith, a dielectric glass was verified as not suffering from the generation of voids near to the dielectric glass in the vicinity of the interface between the Cu-Al alloy electric conductor and the dielectric glass.

Some working examples illustrating preferred embodiments of the present invention will be described below.

### (EXAMPLE 1)

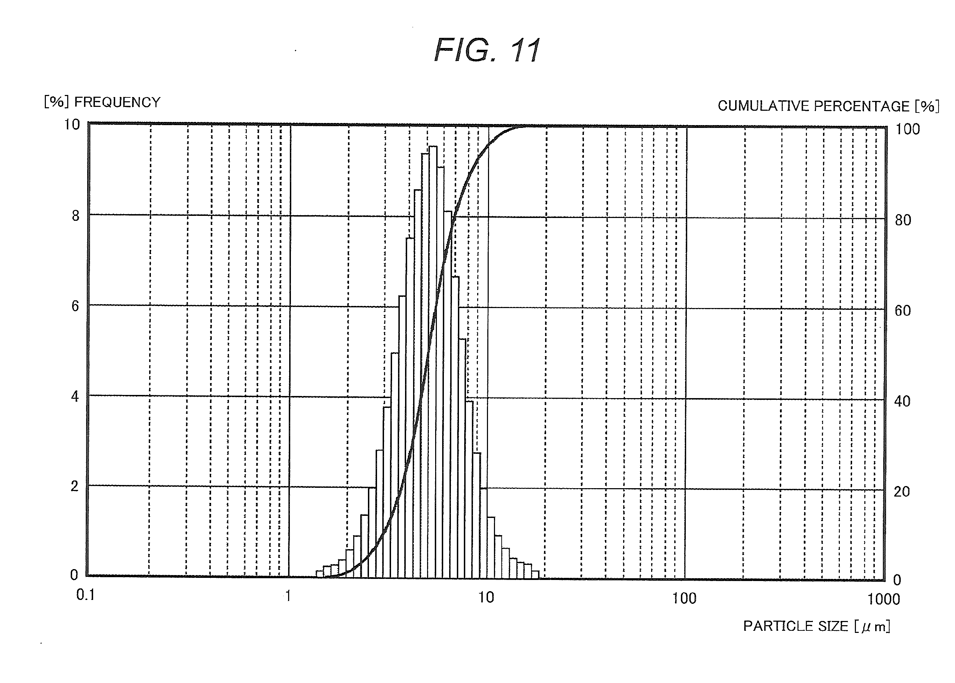

This example illustrates an embodiment of the control of the grain size distribution of a Cu-Al alloy powder, which control is important for cost reduction in method for manufacturing forming an electrode, a wiring, and/or a contact member of an electronic component. Specifically, a yield of 90% or more with respect to materials charged in the alloymelting step could be attained according to the present invention in the method for manufacturing a Cu-Al alloy powder including the steps of melting a Cu-Al alloy; powdering the molten alloy by spraying from a nozzle; drying the powder; classifying the dried powder; blending the classified powder; and deoxidizing/dehydrating the powder. This was achieved by controlling the maximum of particle size in particle size distribution of the Cu-Al alloy powder (spherical) to a diameter of 30 µm or less and controlling the average particle size of the alloy powder to 5 µm or less. An exemplary particle size distribution of the Cu-Al alloy powder in this case is shown in Fig. 11. In addition, a flaky Cu-Al alloy powder was manufactured from the powder (spherical) typically with a ball mill, and the flaky powder was mixed with the powder (spherical) to give a Cu-Al alloy powder containing the flaky powder in a content of 20 percent by weight, from which an electrode was prepared. The resulting electrode was capable of having a lower electric resistance of about nine-tenths to about three-tenths that of an electrode formed from the spherical powder alone. The flaky powder was formed by compressing the powder in the form of particles and had a maximum diameter (major axis) of from 4 to 5 µm and a thickness of 1 µm or less.

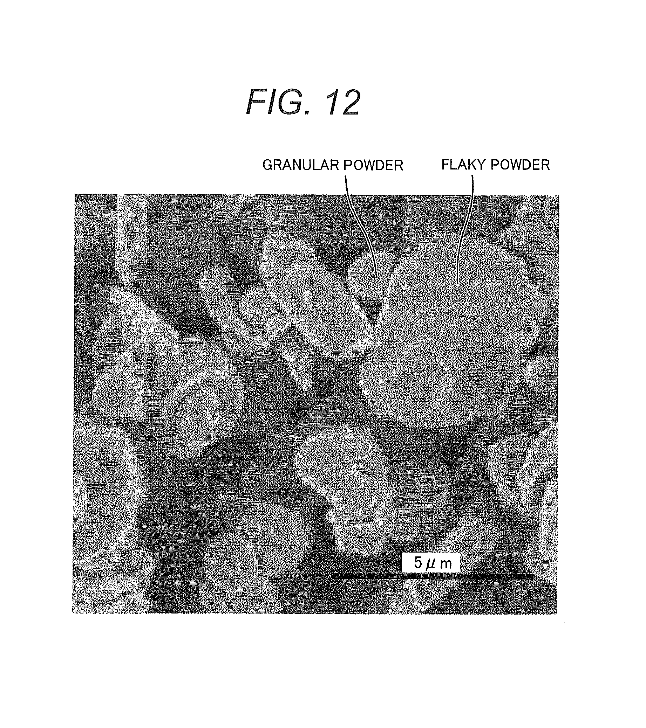

Fig. 12 depicts a scanning electron micrograph (SEM) of the Cu-Al alloy powder containing the flaky powder and demonstrates that the manufactured Cu-Al alloy powder contains the flaky powder and the spherical powder blended with each other and has a maximum of its powder particle size of 5 µm or less.

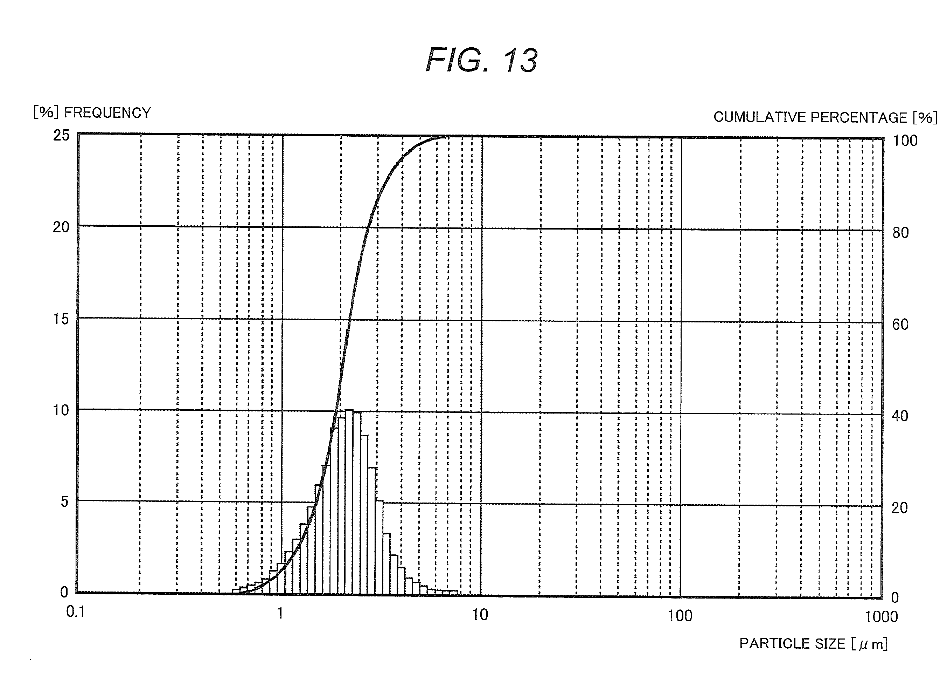

Next, Fig. 13 depicts the particle size distribution of another Cu-Al alloy powder having a maximum of particle size (diameter) of 8 µm or less in particle size distribution. This was prepared from the viewpoint of a "best mix" between the cost and the thickness of an electrode for an electronic component. The Cu-Al alloy powder had an average particle size of 1 µm. The Cu-Al alloy powder gave an electrode having an electric resistance sufficiently less than 5x 10⁻⁶ Ωcm and could be obtained in a yield of 85% or more with respect to materials charged in the alloy melting step.

### (EXAMPLE 2)

This example illustrates exemplary classifying processes for the control of particle size distribution of a Cu-Al alloy powder in the manufacturing method of the Cu-Al alloy powder according to the present invention. The manufacturing method includes the steps of melting a Cu-Al alloy; powdering the molten alloy by spraying from a nozzle; drying the powder; classifying the dried powder; blending the classified powder; and deoxidizing/dehydrating the powder. Initially, an exemplary classification through low-cost spontaneous precipitation will be illustrated below as an example of wet classification. Initially, Cu-Al alloy powder particles (Al: 8 percent by weight, density: 8.4 g/cm³) according to the present invention were prepared by water atomization. The water atomization includes the steps of melting a Cu-Al alloy for use in the present invention; powdering the molten alloy by spraying from a nozzle; drying the powder; classifying the dried powder; blending the classified powder;and deoxidizing/dehydratingthe powder. To 200 g of the Cu-Al alloy powder particles were added a surfactant polyacrylic acid in an amount of 0.8 percent by weight with respect to the particles, and water up to 1000 g; and the resulting suspension was placed in a plastic container. The suspension with the plastic container was placed in an ultrasonic cleaner, and treated therein for 30 minutes with agitation of the suspension.

Based on the Stokes' equation, the agitation speed V in this case is expressed by V = {(Particle size)2x[(Alloy density)-(Solution density)]xGravity}/{18x(Fluid viscosity)}. The suspension after the dispersing treatment was placed in a plastic container to a height of 10 cm. The viscosity of the suspension was measured with an Ubbelohde viscometer and was found to be 0.995 Pa·s. The density of the suspension was found to be 1.001 g/cc, being substantially equal to that of water. According to the Stokes' equation, particles having diameters of 8.3 µm or more are to precipitate at the bottom of the plastic container by leaving the suspension stand for 10 hours. Actually, the suspension was left stand for 10 hours, the supernatant was collected by drawing with a tube pump, and the particle size of particles contained in the supernatant was measured with a particle size analyzer through laser scattering method to find to be 1. 5 µm in terms of median diameter (D50%) and 7 µm in terms of D99%. The suspension was subjected to a treatment in an ultracentrifuge at 1500 rpm for 10 minutes to separate alloy particles from a surfactant aqueous solution, followed by drying at 100°C for 1 hour, to yield alloy particles. As another embodiment, dry classification can also be employed. In this case, an alloy powder as with the wet-classified powder was obtained by using a classifier attached to a dry jet-mill pulverizer.

### (EXAMPLE 3)

An embodiment in which an electrode according to the present invention is adopted to a double-sided electrode crystalline silicon (Si) solar cell element according to the present invention will be described. Figs. 2, 3, and 4 schematically illustrates a cross section, a light-receiving surface, and a back surface, respectively, of the solar cell element.

A semiconductor substrate 130 of the solar cell element generally employs, for example, monocrystalline or polycrystalline silicon. The semiconductor substrate 130 contains, for example, boron to serve as a p-type semiconductor. The light-receiving surface has depressions and protrusions formed through etching so as to suppress the reflection of sunlight. The light-receiving surface is doped typically with phosphorus to form an n-type semiconductor diffusion layer 131 having a thickness on the order of submicron, and a p-n junction is formed at the interface with the p-type bulk. In addition, an antireflection layer 132 typically of silicon nitride is formed to a thickness of about 100 nm on the light-receiving surface typically through vapor deposition.

Next, a front electrode (light-receiving surface electrode) 133 formed on the light-receiving surface, and a collecting electrode 134 and an output-extracting electrode formed on the back surface will be described.

According to customary techniques, the front electrode 133 and the output-extracting electrode 135 employ a silver electrode paste containing a glass powder, whereas the collecting electrode 134 employs an aluminum electrode paste containing a glass powder, in which these pastes are applied through screen process printing. After being dried, the applied pastes are fired at a temperature of from about 500°C to 800°C in the atmosphere and thereby yield the electrodes. In the light-receiving surface in this process, the glass composition contained in the front electrode 133 reacts with the antireflection layer 132, and this allows an electric connection between the front electrode 133 and the diffusion layer 131. In the back surface, aluminum contained in the collecting electrode 134 migrates into the back surface of the semiconductor substrate 130 to form an electrode-component-diffusion layer 136, and this gives ohmic contacts of the semiconductor substrate 130 with the collecting electrode 134 and with the output-extracting electrode 135.

As a working example of the present invention, a solar cell element illustrated in Figs. 2 to 4 was prototyped by adopting Cu-Al alloy powder particles and a phosphate solution to the front electrode 133 and the output-extracting electrode 135. The Cu-Al alloy powder particle used herein was a powder prepared by manufacturing a Cu-Al alloy powder (spherical) by a method for manufacturing a Cu-Al alloy powder including the steps of melting a Cu-Al alloy; powdering the molten alloy by spraying from a nozzle; drying the powder; classifying the dried powder; blending the classified powder; and deoxidizing/dehydrating the powder. The alloy powder was controlled to have an average particle size of 5 µm and had, on its surface, a 50-nm thick aluminum oxide film (Al₂O₃). To 100 parts by weight of the Cu-Al alloy powder particle was added 30 parts by weight of the phosphate solution, and ultrasound was applied thereto for 30 minutes to disperse the metal particles in the phosphate solution. This was used as a paste for the front electrode 133 and for the output-extracting electrode 135.

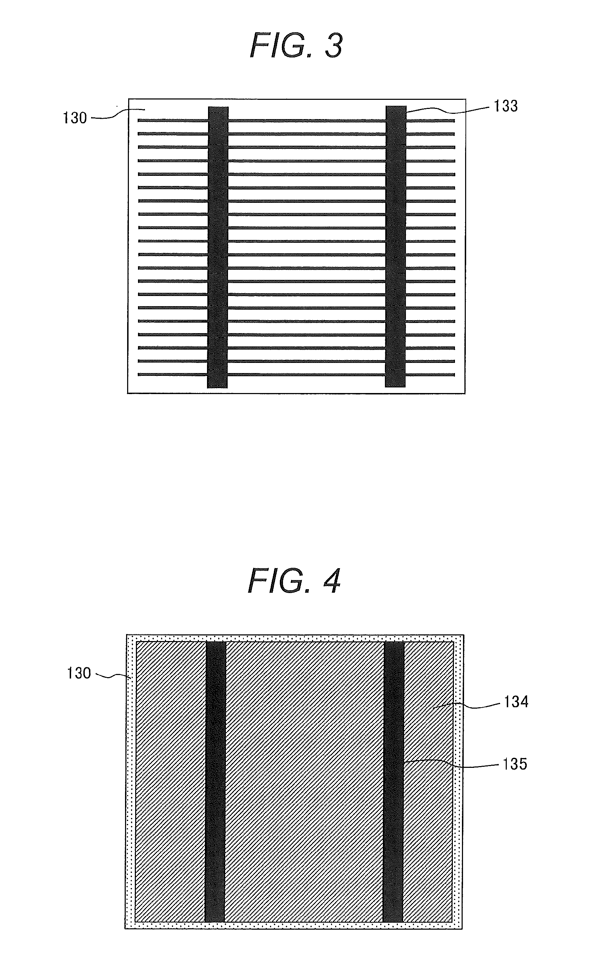

Initially, the aluminum electrode paste for the collecting electrode 134 was applied to the back surface of a semiconductor substrate 130 as illustrated in Figs. 2 and 4 by screen process printing, dried, and heated to 600°C in the atmosphere in an infrared rapid heating furnace. The work was held at 600°C for 3 minutes. Thus, the collecting electrode 134 was initially formed on the back surface of the semiconductor substrate 130.

Next, the above-prepared paste was applied, through screen process printing, to the light-receiving surface of the semiconductor substrate 130 already bearing a diffusion layer 131 and an antireflection layer 132 and to the back surface of the semiconductor substrate 130 already bearing the collecting electrode 134 as illustrated in Figs. 2 to 4, dried, and heated to 750°C in the atmosphere in an infrared rapid heating furnace. The work was held at 750°C for 1 minute.

In the light-receiving surface of the prepared solar cell element, the front electrode 133 was electrically connected to the semiconductor substrate 130 bearing the diffusion layer 131. In the back surface, an electrode-component-diffusion layer 136 was formed, which allowed ohmic contacts of the semiconductor substrate 130 with the collecting electrode 134 and with the output-extracting electrode 135. The specimen was subjected to a damp heat test at 85°C and 85% for 100 hours and was found that the specimen hardly suffered from increase in wiring resistance and contact resistance of the electrodes.

Even when the Al content as the chemical composition of Cu-Al alloy powder particle to be used was varied from 8 percent by weight to 50 percent by weight, the resulting solar cell elements operated as above, verifying that selection of various chemical compositions of the Cu-Al alloy particle is possible. Independently, the respective electrodes could be formed even through a heat treatment of the light-receiving surface and the back surface at 800°C for 3 seconds, indicating that heat treatment conditions can be chosen so as to match various solar cell element structures, as long as the heat treatment is performed at a temperature of 1050°C or lower.

These results demonstrate that the electrodes formed according to the present invention can be developed as electrodes for solar cell elements. In addition, the electrodes can serve as an alternate for the expensive silver (Ag) electrodes and thereby also contribute to cost reduction.

### (EXAMPLE 4)

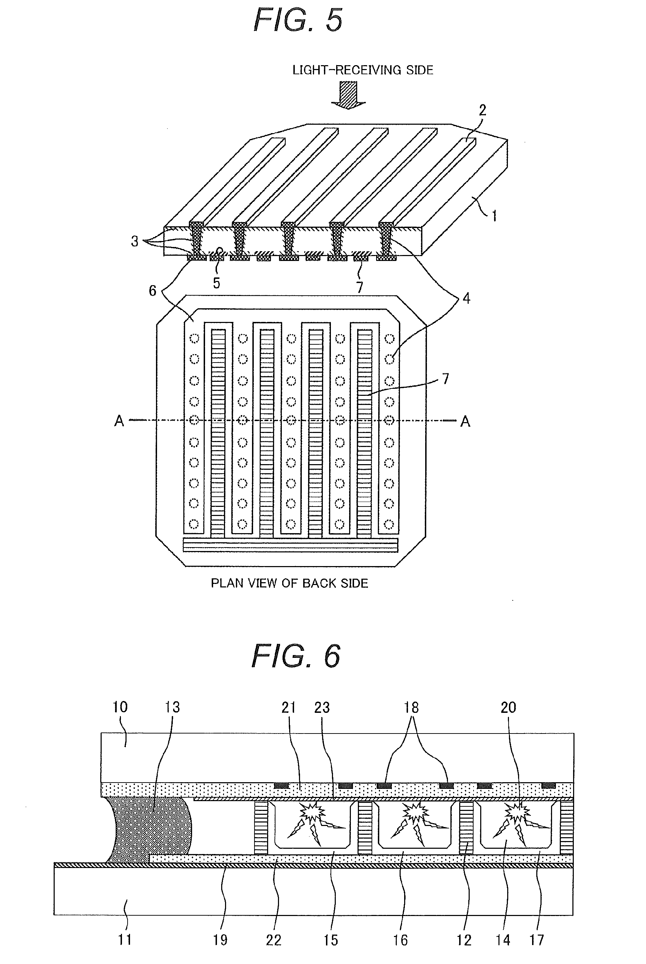

Fig. 5 illustrates an embodiment in which a Cu-Al alloy paste according to the present invention is adopted to, as a crystalline silicon (Si) solar cell, a back-contact (back electrode) solar cell centrally bearing electrodes on the back surface side. Fig. 5 depicts a plan view of the electrode structure on the back surface side and a perspective view of the sectional structure taken along Line A-A. The Cu-Al alloy powder particle used has been prepared by manufacturing a Cu-Al alloy powder (spherical) by a method for manufacturing a Cu-Al alloy powder. This process includes the steps of melting a Cu-Al alloy; powdering the molten alloy by spraying from a nozzle; drying the powder; classifying the dried powder; blending the classified powder; and deoxidizing/dehydrating the powder. The alloy powder is controlled to have an average particle size of 1 µm and has, on its surface, a 40-nm thick aluminum oxide film (Al₂O₃).

In this embodiment, through holes are formed typically by laser drilling or etching as penetrating through upper and lower sides of a cell wafer 1 composed typically of a p-type Si substrate. Subsequently, a manufacturing method through the same procedure as in a customary crystalline silicon solar cell described in Example 1 is performed to form a texture (not shown) for improving light incident efficiency, to formann-type layer 3 by a diffusion treatment of the light-receiving surface side, and to form an antireflection film (not shown). Next, the Cu-Al alloy paste according to the present invention is charged into the already formed through hole through printing or ink-jet process, and the Cu-Al alloy paste according to the present invention is printed in the form of a grid on the light-receiving surface side, and thereby yields through-hole electrodes 4 and collecting grid electrodes 2, respectively. The paste for charging and the paste for printing are preferably those having optimum viscosities and compositions suitable for the respective processes, respectively, but it is acceptable that a paste having the same composition is used for charging and for printing all together.

The formation of the collecting grid electrodes 2 on the light-receiving surface is not essential. The resulting cell may function as a cell also by forming the through-hole electrodes 4 to the partway of the entire thickness of the Si substrate, and this configuration may increase the area and efficiency of the light-receiving surface. In this case, it has been verified that through-hole electrodes 4 and a back electrode 6 may be prepared from the Cu-Al alloy, or even when the through-hole electrodes 4 are prepared typically from Ag and the back electrode 6 alone is prepared from the Cu-Al alloy, the electrodes do not lose their functions. Independently, a densely doped layer 5 for preventing carrier recombination is formed on the opposite side to the light-receiving surface.

As a dopant (impurity element) for forming the densely doped layer, boron (B) or aluminum (Al) is used to form a p+ layer. In this example, a thermal diffusion treatment using, for example, boron as a diffusion source may be performed in a cell production process prior to the formation of the antireflection film. Alternatively, when Al is used, an Al paste may be printed to the opposite side in the printing process. Subsequently firing at 600°C to 1000°C is performed, and the alloy paste charged into the through hole and printed onto the antireflection film formed on the light-receiving surface side can have an ohmic contact with the lower n-type layer by the action of fire-through effect.

Finally, back electrodes 6 and 7 are formed on the opposite side by printing the alloy paste according to the present invention respectively as n-side and p-side in the form of stripes as illustrated in the plan view in Fig. 5, and firing the applied paste. The above-described process is illustrated as a typical example of a manufacturing method of a back-contact solar cell, and it should be noted that the present invention is adoptable to all solar cell structures in which an n-type electrode is formed through a through hole on the back surface side.

This embodiment, as employing the Cu-based Cu-Al alloy paste, can give a solar cell having a back contact side, which solar cell is very inexpensive and has less resistance loss (higher electrical efficiency) as compared to the customary paste material mainly containing Ag. The embodiment, as having a small conductor resistance, also allows the formation of further finer and thinner grid and through-hole electrodes, and this further reduces a loss of light incident in the light-receiving surface and thereby gives a synergistic effect with the reduction in amount of materials to be used. The specimen herein was further subjected to a damp heat test at 85°C and 85% for 100 hours and was found to hardly suffer from increase in wiring resistance and contact resistance of the electrodes.

Even when the Al content as the chemical composition of Cu-Al alloy powder particle to be used was varied in a range from 8 percent by weight to 50 percent by weight, the resulting solar cell elements operated as above, verifying that selection of various chemical compositions of the Cu-Al alloy particles is possible. Independently, the respective electrodes could be formed even through a heat treatment of the light-receiving surface and the back surface at 800°C for 3 seconds, indicating that heat treatment conditions can be chosen so as to match various solar cell element structures, as long as the heat treatment is performed at a temperature of 1050°C or lower.

### (EXAMPLE 5)

An embodiment in which the present invention is adopted to a plasma display panel will be illustrated. Fig. 6 depicts a schematic cross-sectional view of the plasma display panel.

In the plasma display panel, a front substrate 10 and a rear substrate (back substrate) 11 are arranged so as to face each other at a distance of from 100 to 150 µm, and the distance between the respective substrates is maintained by ribs 12. The peripheries of the front substrate 10 and the rear substrate 11 are hermetically sealed with a sealing material 13, and a rare gas (noble gas) is charged into the inside of the panel. Fine spaces (cells 14) partitioned by the ribs 12 are filled with phosphors. Three cells of three colors filled with red, green, and blue phosphors 15, 16, and 17, respectively, constitute one pixel. Respective pixels emit light of respective colors according to signals.

The front substrate 10 and the rear substrate 11 each include a glass substrate and, regularly arrayed thereon, electrodes. A display electrode 18 of the front substrate 10 and an address electrode 19 of the rear substrate 11 form a pair, and, between this pair, a voltage of 100 to 200 V according to a display signal is selectively applied to cause discharge between the electrodes. The discharge generates an ultraviolet ray 20 to allow the phosphors 15, 16, and 17 to emit light, thus displaying image information. The display electrodes 18 and the address electrodes 19 are covered by dielectric layers 21 and 22, respectively, typically for protecting these electrodes and for controlling wall charges upon discharging. The dielectric layers 21 and 22 may employ thick glass.

In the rear substrate 11, the ribs 12 are provided on the dielectric layer 22 of the address electrodes 19, so as to form the cells 14. The ribs 12 each have a structure in the form of stripe or box.

A silver (Ag) thick-film wiring is generally employed in the display electrodes 18 and the address electrodes 19 according to customary techniques.

As is described above, however, a Cu thick-film wiring is preferably used instead of the Ag thick-film wiring so as to reduce cost and to prevent Ag migration. Exemplary necessary conditions for this purpose are that, upon the formation and firing of the Cu thick-film wiring in an oxidative atmosphere, the resulting Cu thick-film wiring is protected from having a lower electric resistance due to oxidation of Cu; that, upon the formation and firing of a dielectric layer in an oxidative atmosphere, the Cu thick-film wiring is protected from having a lower electric resistance due to oxidation of Cu, which is in turn due to the reaction between Cu and the dielectric layer; and that the Cu thick-film wiring is protected from having a lower withstanding voltage due to the generation of voids (bubbles) in the vicinity thereof. The display electrodes 18 and the address electrodes 19 may be formed by sputtering, but they are preferably formed through printing for cost reduction. The dielectric layers 21 and 22 are generally formed through printing. The display electrodes 18, address electrode 19, and dielectric layers 21 and 22, when formed through printing, are generally fired at a temperature in the range of from 450°C to 620°C in an oxidative atmosphere.

The display electrodes 18 are formed on the surface of the front substrate 10 so as to be perpendicular to the address electrodes 19 of the rear substrate 11, and thereafter the dielectric layer 21 is formed allover. A protective layer 23 is formed on the dielectric layer 21 so as to protect, for example, the display electrodes 18 from discharge. In general, the protective layer 23 employs a MgO deposited film. Independently, in the rear substrate 11, the address electrodes 19 are formed, and the dielectric layer 22 is then formed in cell-forming regions, on which the ribs 12 are provided. The ribs each including a glass structure are made from a structural material containing at least a glass composition and a filler, and include a fired article obtained through sintering of the structural material. The ribs 12 may be formed in the following manner. A volatile sheet having trenches corresponding to ribs to be formed is applied, and a paste for ribs is poured into the trenches, followed by firing at 500°C to 600°C, to thereby evaporate the sheet and to form the ribs 12 simultaneously.

The ribs 12 may also be formed by applying a paste for ribs overall through printing; drying the applied paste; removing unnecessary portions through sand blasting or chemical etching while masking; and firing the residual portions at 500°C to 600°C. Pastes of phosphors 15, 16, and 17 of respective colors are charged into cells 14 partitioned by the ribs 12, fired at 450°C to 500°C, and thereby yield the phosphors 15, 16, and 17, respectively.

The front substrate 10 and the rear substrate 11, which have been generally separately prepared, are arranged so as to face each other, are precisely aligned, and the peripheries of which are sealed with glass at 420°C to 500°C. The sealing material 13 is previously formed by dispensing or printing on the periphery of at least one of the front substrate 10 and the rear substrate 11.

In general, the sealing material 13 is formed on the periphery of the rear substrate 11. The sealing material 13 may be calcined simultaneously with the firing of the phosphors 15, 16, and 17. This process, when employed, can significantly reduce bubbles in a glass sealing portion, and this allows the glass sealing portion to have high hermeticity, i.e., to have high reliability. While heating for sealing with glass, gases in the cells 14 are evacuated, and a rare gas is sealed therein, and a panel is completed. The sealing material 13 may come in direct contact with the display electrodes 18 and/or the address electrodes 19 upon calcination of the sealing material 13 and/or sealing with the glass. In this case, the wiring material constituting the electrodes may react with the sealing material 13 to thereby have an increased electric resistance. However, the increase in electric resistance is unfavorable, and the reaction should therefore be avoided.

To light the completed panel, a voltage is applied to a portion where a display electrode 18 and an address electrode 19 intersect with each other. Thus, the rare gas in a cell 14 discharges to become into a plasma state. The rare gas in the cell 14 emits an ultraviolet ray 20 when it returns from the plasma state to an original state, and by the action of the ultraviolet ray 20, a phosphor 15, 16, or 17 is allowed to emit light. Thus, the panel is lit to display image information. To light a color, an address discharge is performed between a display electrode 18 and an address electrode 19 corresponding to a cell 14 of the color to be lit to accumulate wall charges in the cell. Next, a predetermined voltage is applied to the pair of display electrodes, and this allows only the cell, in which wall charges due to the address discharge have been accumulated, to undergo a display discharge to thereby emit an ultraviolet ray 20. According to this mechanism, the target phosphor is allowed to emit light to thereby display image information.

Initially, a preliminary investigation was made about whether or not a wiring material containing a Cu-Al alloy powder according to the present invention and a glass powder is adoptable to the display electrodes 18 of the front substrate 10, and to the address electrodes 19 of the rear substrate 11. The Cu-Al alloy powder particle used herein was a powder particle prepared by manufacturing a Cu-Al alloy powder (spherical) by a method for manufacturing a Cu-Al alloy powder including the steps of melting a Cu-Al alloy; powdering the molten alloy by spraying from a nozzle; drying the powder; classifying the dried powder; blending the classified powder; and deoxidizing/dehydrating the powder. The alloy powder was controlled to have an average particle size of from 1 to 2 µm and had, onits surface, a 40-nm thick aluminum oxide film (Al₂O₃).

A series of wiring pastes was prepared by blending the Cu-Al alloy powder having an average particle size of from 1 to 2 µm with a glass powder having an average particle size of 1 µm in various proportions, and adding a binder and a solvent to the resulting mixtures. The glass powder used herein was a lead-free low-temperature softening glass having a softening point of around 450°C; the binder was ethylcellulose; and the solvent was butyl Carbitol acetate. Each of the prepared wiring pastes was applied to a glass substrate for a plasma display panel through printing, heated at 530°C in the atmosphere for 30 minutes, and thereby yielded a series of wirings. The electric resistance of prepared wirings was measured, fromwhich a specific resistance was determined.

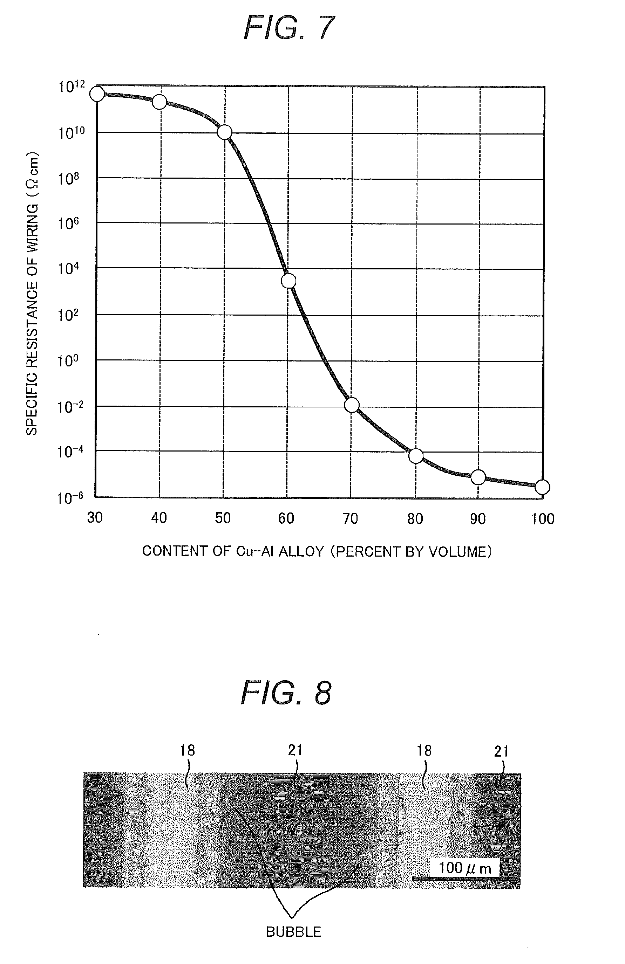

Fig. 7 illustrates how the specific resistance of a wiring varies depending on the content of the Cu-Al alloy powder according to the present invention. The data demonstrate that wirings having a content of Cu-Al alloy powder of 75 percent by volume or more (a content of glass powder of 25 percent by volume or less) are hardly oxidized and have a sufficiently low specific resistance. Accordingly, a Cu-Al alloy powder according to the present invention can be used as a wiring material by controlling the glass powder content to be 25 percent by volume or less. The content of the Cu-Al alloy powder is more preferably 85 percent by volume or more. This is because further satisfactory oxidation resistance can be imparted to the wiring material by regulating the content of Cu-Al alloy powder to be 85 percent by volume or more (regulating the content of glass powder to be 15 percent by volume or less). In such cases, regarding the chemical composition of the Cu-Al alloy powder, Al, when added in a content of from 5 to 50 percent by weight to Cu, imparts oxidation resistance to the powder.

A wiring, when containing the glass powder in an excessively low content, was liable to be peeled off from the glass substrate serving as the front substrate or rear substrate. In contrast, a wiring, when having a glass powder content of 3 percent by volume or more, could be formed as firmly fixing to the glass substrate. Specifically, a paste, when containing the Cu-Al alloy powder in a content of from 65 to 97 percent by volume and the glass powder in a content of from 3 to 35 percent by volume, is effectively usable as a wiring material. For a lower electric resistance, the glass powder content in its upper limit is preferably 25 percent by volume or less, and more preferably 15 percent by volume or less. The wiring material, when further containing a low-thermal expansion filler powder, gives a wiring that is more resistant to peeling (delamination). However, the amount of the low-thermal expansion filler powder should generally be 20 percent by volume or less, because the addition of such a filler powder may cause the wiring to have a higher specific resistance.

As a comparative example for confirmation, another test was performed by using a pure Cu powder as a wiring material. However, the material was significantly oxidized during heating at 530°C in the atmosphere and failed to be used as a wiring material.

Based on the results of investigations, there was selected a wiring material containing 85 percent by volume of a Cu-Al alloy powder having an average particle size of from 1 to 2 µm and 15 percent by volume of a glass powder having an average particle size of 1 µm. By adopting the selected wiring material to the display electrodes 18 of the front substrate 10 and to the address electrodes 19 of the rear substrate 11, a plasma display panel illustrated in Fig. 6 was prototyped. This wiring material was mixed with ethylcellulose as a binder and butyl Carbitol acetate as a solvent by the above procedure and thereby yielded a wiring paste. This was applied to a front substrate 10 and a rear substrate 11 through printing, fired at 530°C in the atmosphere for 30 minutes, and thereby formed display electrodes 18 and address electrodes 19. In addition, these were covered with glass as dielectric layers 21 and 22.

In the same way as above, the glass serving as the dielectric layers 21 and 22 was prepared by mixing a glass powder having an average particle size of 1 µm with a binder and a solvent to give a paste; applying the paste to substantially the entire surface of the article through printing; and firing the article at 610°C in the atmosphere for 30 minutes. The glass powder used herein was a lead-free glass having a softening point of around 560°C; the binder was ethylcellulose; and the solvent was butyl Carbitol acetate. The front substrate 10 and the rear substrate 11 were separately prepared, the outer peripheries of the two substrates were sealed with each other using a glass, and thereby yielded a plasma display panel. It was found that the display electrodes 18 and the address electrodes 19 using the wiring material according to the present invention can be mounted into the panel without discoloration due to oxidation and without the generation of voids at interfaces between the display electrodes 18 and the dielectric layer 21 and those between the address electrodes 19 and the dielectric layer 22.

Subsequently, the prepared plasma display panel was subjected to a lighting test. The panel could be lit without increase in electric resistance of the display electrodes 18 and the address electrodes 19, without reduction in withstanding voltage, and without migration as with Ag. No trouble was observed in other points.

Fig. 8 illustrates a sample in which the display electrodes 18 were formed from pure Cu, indicating that bubbles were generated along with the display electrodes 18 at interfaces with the dielectric layer 21, due to oxidation of the display electrodes 18. This sample suffered from reduction in withstanding voltage, thus being problematic. In contrast to this, the display electrodes using the Cu-Al alloy according to the present invention exhibited satisfactory properties without suffering from the generation of bubbles at all.

### (EXAMPLE 6)

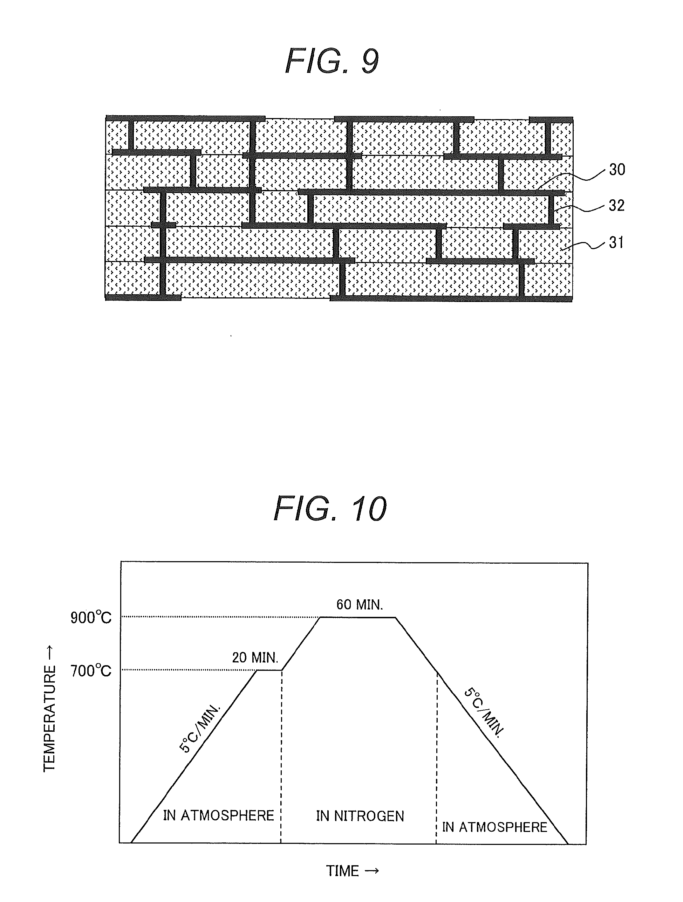

In this example, a multilayer (five layered) wiring board of low temperature co-fired ceramics (LTCC) illustrated in Fig. 9 was manufactured. A wiring (interconnection) 30 is formed three-dimensionally. According to this manufacturing method, a green sheet 31 is initially prepared from a glass powder and a ceramic powder, and through holes 32 are made at desired positions. Next, a paste for interconnection 30 is applied to a front surface of the green sheet 31 through printing and is also charged into the through holes 32. Where necessary, the paste for interconnection 30 is also applied to the back surface of the green sheet 31 through printing. This application process is performed after drying of the paste for interconnection 30 applied on the front surface of the green sheet 31.

Green sheets 31 each thus prepared and bearing a layer of the paste for interconnection 30 are stacked, generally fired at around 900°C in the atmosphere, and thereby yields a LTCC multilayer wiring board. An expensive Ag paste has been used as the paste for interconnection 30. When a Cu paste, which is advantageously resistant to migration and is inexpensive, is used, the paste is fired in a nitrogen atmosphere, but is difficult to give a dense multilayer wiring board because of insufficient removal of the binder. The resulting interconnection 30 also suffers from increase in electric resistance because Cu is oxidized at a portion where the glass in the green sheet 31 is in contact with Cu in the interconnection 30 and the glass softens and/or flows. In addition, voids (bubbles) due to the reaction between Cu and the glass may be generated at the interface between the two components. This may cause the interconnection 30 to be broken, thus being an unfavorable phenomenon.

In this example, a Cu-Al alloy powder according to the present invention was used as a paste for interconnection 30. The Cu-Al alloy powder particle used herein was a powder particle prepared by manufacturing a Cu-Al alloy powder (spherical) by a method for manufacturing a Cu-Al alloy powder. The method includes the steps of melting a Cu-Al alloy; powdering the molten alloy by spraying from a nozzle; drying the powder; classifying the dried powder; blending the classified powder; and deoxidizing/dehydrating the powder. The alloy powder was controlled to have an average particle size of 1 µm and had, on its surface, a 40-nm thick aluminum oxide film (Al₂O₃).

Nitrocellulose giving less residual carbon was used as a binder, whereas butyl acetate was used as a solvent. Using a paste for interconnection 30 including these materials, a multilayer (five layered) wiring board illustrated in Fig. 15 was manufactured. The heat treatment conditions for firing the multilayer wiring board were determined as follows. Specifically, a Cu-Al alloy according to the present invention (in this example, a Cu-Al alloy containing 8 percent by weight of Al) is not thoroughly oxidized at temperatures up to 800°C in an oxidative atmosphere. For this reason, the multilayer wiring board was heated at temperatures up to and down from 700°C in the atmosphere (in the air) and heated at temperatures from 700°C to 900°C in a nitrogen atmosphere, as in a temperature profile illustrated in Fig. 10. In this process, the multilayer wiring board was held at 900°C in the nitrogen atmosphere for 60 minutes, cooled to 700°C, and at this time point, the heating atmosphere was returned to the atmosphere (air). The manufactured multilayer wiring board, from which the binder was substantially completely removed at temperature down to 700°C, was densely fired.

The interconnection 30 made from the Cu-Al alloy was hardly oxidized and did not suffer from increase in electric resistance. In addition, the interconnection 30 did not suffer from the generation of voids in the vicinity thereof due to the reaction with the glass, and the resulting multilayer wiring board thereby had both higher performance and lower cost. The temperature profile and atmospheres for use in the heat treatment are not limited to those mentioned above, and similar effects could be obtained through a heat treatment at 900°C in the atmosphere when using a Cu-Al alloy having an Al content of 15 percent by weight or more.

### Industrial Applicability

The present invention is applicable to Cu-Al alloy powders and various pastes including the same which are usable for the formation typically of wirings, electrodes, and/or contacts of various electronic components.

### Reference Signs List

- 1:: cell wafer including a p-type silicon substrate
- 2:: collecting grid electrode
- 3:: n-type layer
- 4:: through-hole electrode
- 5:: densely doped layer
- 6, 7:: back electrode
- 10:: front substrate
- 11:: rear substrate
- 12:: rib
- 13:: sealing material
- 15, 16, 17:: red, green, and blue phosphors
- 18:: display electrode
- 19:: address electrode
- 20:: ultraviolet ray
- 21, 22, 402:: dielectric layer
- 23:: protective layer
- 30:: interconnection
- 31:: green sheet
- 32:: through hole
- 130:: semiconductor substrate
- 131:: diffusion layer
- 132:: antireflection layer
- 133:: front electrode
- 134:: collecting electrode
- 135:: output-extracting electrode
- 136:: electrode-component-diffusion layer

## Claims

1. A Cu-Al alloy powder comprising a powder of Cu-Al alloy including copper (Cu) and aluminum (Al) ; and an aluminum oxide film being present on a surface of the powder of Cu-Al alloy and having a thickness of 80 nm or less.

2. The Cu-Al alloy powder according to claim 1, wherein the Cu-Al alloy constituting the powder of Cu-Al alloy has an alloy composition comprising Al in a content of 50 percent by weight or less, with the remainder being Cu and inevitable impurities.

3. The Cu-Al alloy powder according to claim 1 or 2, wherein the powder of Cu-Al alloy has a spherical shape and has an average particle size distribution of 30 µm or less.

4. The Cu-Al alloy powder according to any one of claims 1 to 3, further comprising a flaky Cu-Al alloy powder.

5. The Cu-Al alloy powder according to any one of claims 1 to 3, wherein the Cu-Al alloy powder has an average particle size of 5 µm or less.

6. The Cu-Al alloy powder according to any one of claims 1 to 3, wherein the Cu-Al alloy powder has a maximum of particle size of 5 µm or less in particle size distribution.

7. The Cu-Al alloy powder according to any one of claims 1 to 3, wherein the Cu-Al alloy powder has an average particle size of 5 µm or less and has a maximum of particle size of 30 µm or less in particle size distribution.

8. A method for manufacturing a Cu-Al alloy powder, the method comprising the steps of melting a Cu-Al alloy; spraying the molten alloy from a nozzle to give a powder; drying the powder; classifying the dried powder; blending the classified powder; and deoxidizing/dehydrating the blended powder.

9. The method for manufacturing a Cu-Al alloy powder according to claim 8, further comprising the step of performing a heat treatment in which the Cu-Al alloy powder is exposed to the air or an oxygen-present atmosphere, wherein the Cu-Al alloy powder has a weight gain on oxidation of 5 percent by weight or less.

10. The method for manufacturing a Cu-Al alloy powder according to claim 8 or 9, wherein the powder classifying step is performed by dry gas classification or wet submerged classification.

11. A Cu-Al alloy paste comprising the Cu-Al alloy powder of any one of claims 1 to 7; and at least one selected from the group consisting of a glass, a solvent, and a binder.

12. The Cu-Al alloy paste according to claim 11, further comprising at least one powder selected from the group consisting of a silver (Ag) powder, an aluminum (Al) powder, a silicon (Si) powder, and a gold (Au) powder; and at least one selected from the group consisting of a glass, a solvent, and a binder.

13. The Cu-Al alloy paste according to claim 11, further comprising at least one of an alkali metal oxide powder and an alkali metal carbonate.

14. An electronic component comprising a Cu-Al alloy coating as an electric conductor of at least one selected from the group consisting of a wiring, an electrode, and a contact member, the Cu-Al alloy coating having been formed by applying the Cu-Al alloy paste of any one of claims 11 to 13 to a substrate; and firing the applied paste in the air or in an oxygen-containing atmosphere.

15. The electronic component according to claim 14, wherein the electric conductor has an electric resistance of 50 µΩcm or less.

16. The electronic component according to claim 14 or 15, as one selected from the group consisting of a system-on-a-film, a tape carrier package, a low-temperature co-fired ceramic multilayer wiring board, a plasma display, a liquid crystal display, an organic electroluminescence (EL) display, and a solar cell.

17. The electronic component according to claim 16, wherein the solar cell is a crystalline silicon solar cell.

18. The solar cell according to claim 17, wherein the solar cell is a back-contact solar cell.

19. The electronic component according to any one of claims 14 to 17, wherein the electronic component structurally includes the Cu-Al alloy electric conductor; and a dielectric glass in contact with the Cu-Al alloy electric conductor, and wherein a void is in intimate contact with the dielectric glass in the vicinity of an interface between the Cu-Al alloy electric conductor and the dielectric glass.
